# EUROPEAN PATENT APPLICATION

(11) **EP 4 475 195 A1**
(43) Date of publication of application: **11.12.2024**
(21) Application number: 22924760.6
(22) Date of filing: 02.02.2022
(51) Int. Cl.: H01L 31/042

(54) **METHOD FOR PROCESSING SOLAR CELL MODULE**

(71) Applicant: Dowa Eco-System Co., Ltd., Tokyo 101-0021 (JP)
(72) Inventor: MORITA, Yoshinori, Tokyo 101-0021 (JP); WATANABE, Ryoei, Tokyo 101-0021 (JP); YODOSE, Tatsuya, Tokyo 101-0021 (JP); MIURA, Kengo, Tokyo 101-0021 (JP)
(74) Representative: Müller-Boré & Partner Patentanwälte PartG mbB
(86) International application number: PCT/JP2022/004085
(87) International publication number: WO 2023/148847

(57) **Abstract**

There is provided a method for processing a solar cell module, including: removing a frame member from a solar cell module to obtain a frame-removed material; crushing the frame-removed material to obtain a crushed material; and electrostatically separating the crushed material, wherein in the electrostatic separation, the crushed material is charged and separated in accordance with density and conductivity.

## Description

### Technical Field

The present invention relates to a method for processing a solar cell module.

### Description of Related Art

Solar cell power generation is attracting attention as a renewable energy source because it utilizes a clean energy of sunlight and has a small environmental impact. A solar cell module used for this solar cell power generation is configured to include, for example, solar cells, a sealing member that seals the solar cells, a protective member (so-called back sheet), metal wiring extending from the solar cell, a glass substrate, and a frame member provided around the sealing member.

Conventionally, the solar cell module has been disposed of after a certain period of use, but in recent years, there has been a demand to process the solar cell module and recover valuable metals for recycling.

In view of this, for example, Patent document 1 discloses a method for processing a solar cell module. Patent document 1 describes a method in which a glass substrate of a solar cell module is crushed and separated, and then metal and resin are separated from the residue.

### Prior art document

### Patent document

[Patent Document 1] JP 2015-192942 A

### Summary of the invention

### Problem to be solved by the invention

However, in the above-described processing method, since the sorting of glass and the sorting of metal and resin are performed in separate processes, the processing steps are complicated and it may not be possible to efficiently process a large number of solar cell modules. The solar cell module is constituted of glass, resin, metal wiring (such as a tab wire) and cells in addition to the frame member, and it is effective to concentrate and separate the tab wire and cells from the solar cell module, which are valuable resources.

An object of the present invention is to provide a technique for sorting and concentrating a valuable material from a solar cell module using a simple process.

### Means for solving the problem

In order to solve the above-described problem, the present inventors have focused on crushing a solar cell module as it is without removing a glass substrate, and sorting a resulting crushed material. In this case, the crushed material includes not only metal and resin but also glass, and it is found that electrostatic separation is an effective method for sorting such a crushed material. Electrostatic separation makes it possible to separate the metal, resin, and glass contained in the crushed material, in accordance with their electrical conductivity and density, and even in the crushed material that contains glass, valuables can be sorted and concentrated.

The following aspects have been created based on the above findings.

A first aspect of the present invention provides a method for processing a solar cell module, including:
removing a frame member from a solar cell module to obtain a frame-removed material;
crushing the frame-removed material to obtain a crushed material; and
electrostatically separating the crushed material,
wherein in the electrostatic separation, the crushed material is charged and separated in accordance with density and conductivity.

In a second aspect of the present invention according to the first aspect, the solar cell module includes: a solar cell; metal wiring extending from the solar cell; a sealing member made of resin for sealing the solar cell and the metal wiring; a resin protective member provided on one surface of the sealing member; a glass substrate provided on the other surface of the sealing member; and a frame member surrounding these.

In a third aspect of the present invention according to the first or second aspect, in the crushing, the crushed material is crushed to have a particle size of 5 mm or less.

In a fourth aspect of the present invention according to any one of the first to third aspects, in the electrostatic separation, an applied voltage is set to 18 kV or more and less than 30 kV.

In a fifth aspect of the present invention according to any one of the first to fourth aspects, in the electrostatic separation, the crushed material is supplied to an electrostatic separator equipped with a grounded metal drum electrode, and a rotation speed of the grounded metal drum electrode is set to 20 rpm or more and 60 rpm or less.

In a sixth aspect of the present invention according to any one of the first to fifth aspects, in the electrostatic separation, the crushed material is supplied to an electrostatic separator equipped with a grounded metal drum electrode, and electrostatic separation is repeated one or more times for the separated material from each drop position from the grounded metal drum electrode.

In a seventh aspect of the present invention according to the sixth aspect, in the electrostatic separation, a rotation speed of the grounded metal drum electrode in the electrostatic separation performed in a latter stage is set to be smaller than that in the electrostatic separation performed in a former stage, and/or a voltage applied to the grounded metal drum electrode in the electrostatic separation performed in the latter stage is set to be higher than that in the electrostatic separation performed in the former stage.

### Advantage of the invention

According to the present invention, valuables can be sorted and concentrated from a solar cell module using a simple process.

### Brief description of the drawings

FIG. 1 is a schematic cross-sectional view of a solar cell module.
FIG. 2 is a schematic block diagram of an electrostatic separator.
FIG. 3 is a view showing a flow when first and second electrostatic separation steps are performed.

### Detailed description of the invention

### <One embodiment of the present invention>

A method for processing a solar cell module according to one embodiment of the present invention will be described below.

### (Preparation step)

First, as a processing target, a frame-removed material obtained by removing a frame member from a solar cell module is prepared. Each configuration of the solar cell module and the frame-removed material will be described below.

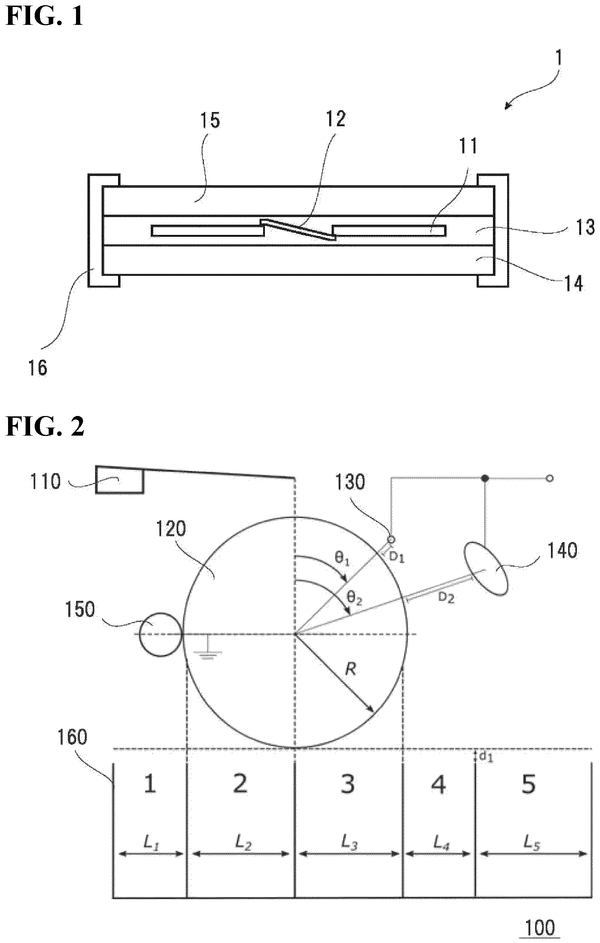

For example, as shown in FIG. 1, the solar cell module 1 is configured including: a plurality of solar cells 11; metal wiring 12 extending from the solar cells 11; a sealing member 13 that seals the solar cells 11 and a metal wiring 12; a protective member 14 provided on one surface of the sealing member 13; a glass substrate 15 provided on the other surface of the sealing member 13; and a frame member 16 that surrounds a laminate including the sealing member 13 and the glass substrate 15.

The solar cell 11 is formed from a semiconductor containing, for example, silicon (Si) and has a surface electrode (not shown) provided on its surface. The surface electrode is formed, for example, mainly containing a metal such as silver (Ag). The metal wiring 12 is extending from the solar cell 11 and electrically connects the solar cells 11 to each other. The metal wiring 12 is mainly composed of a metal such as copper (Cu), for example. The sealing member 13 is made of a resin such as ethylene-vinyl acetate copolymer (EVA) or polyethylene. The protective member 14 is made of a resin such as polyethylene terephthalate (PET) or fluororesin. The glass substrate 15 is made of, for example, glass, and the frame member 16 is made of, for example, a metal or resin.

The frame-removed material is obtained by removing the frame member 16 from the solar cell module 1 by a conventionally known method.

### (Crushing steps)

Next, the frame-removed solar cell module 1 is crushed together with the glass substrate 15, which is a part of the module, to obtain a crushed material.

The crushed material includes silicon powder (Si powder, hereinafter also referred to as cell powder) derived from a semiconductor material forming the solar cell 11, metal powder derived from the metal wiring 12 and the surface electrodes, resin powder derived from the sealing member 13 and the protective member 14, glass powder derived from the glass substrate 15, etc.

In the crushing step, each member is crushed into particles having a particle size according to the material and physical properties of each member.

Since the solar cell 11 (Si) is brittle, it is easily crushed into small pieces, and a particle size of the resulting cell powder tends to be relatively small.

Since the sealing member 13, the protective member 14, etc., are made of a soft and sticky resin, they are roughly crushed, and the particle size of the resulting resin powder tends to be relatively large.

Since the glass constituting the glass substrate 15 is hard, the particle size of the resulting glass powder tends to be relatively large.

The particle size of the crushed material is not particularly limited, but is preferably 5 mm or less. The particle size here indicates a particle size that passes through a sieve with 5 mm openings. The crushed material can be sieved to obtain a crushed material of 5 mm or less. If the particle size is too large, the crushed material becomes heavy, and the crushed material may not be efficiently separated in accordance with its density and electrical conductivity in the electrostatic separation step described below. For example, when the particle size becomes large, metal powder and resin powder become heavy. It is desirable to recover the metal powder as a bouncing matter, but if it is heavy it will be recovered as a falling matter, and if each powder is large and heavy, they will be recovered as a falling matter, making it impossible to sort them. In this regard, by making the particle size of the crushed material 5 mm or less, it is possible to suppress the metal powder and resin powder from falling due to their own weight during the electrostatic separation step, and to efficiently separate each powder. On the other hand, the smaller the particle size of the metal powder, the easier it is to bounce due to charging.

As a crushing method, a conventionally known crushing method, for example, such as shear crushing can be used. Crushing conditions for shear crushing are not particularly limited, but the number of blades, the clearance between the blades, the rotation speed of the blades, etc., may be appropriately adjusted so that the particle size of the crushed material falls within the above range. For example, by crushing the glass powder so that the particle size thereof falls within the above range, the particle size of more brittle metal powder and more sticky resin powder can also fall within the above range.

### (Electrostatic separation step)

The resulting crushed material is then subjected to electrostatic separation. In the present embodiment, the electrostatic separation is performed using an electrostatic separator equipped with a grounded metal drum electrode, and the individual powder contained in the crushed material is separated in accordance with its density and electrical conductivity at each drop position from the grounded metal drum electrode.

First, the electrostatic separator will be described with reference to FIG. 2. FIG. 2 is a schematic view of the electrostatic separator.

For example, as shown in FIG. 2, an electrostatic separator 100 includes: a supply unit 110 for supplying a crushed material; a grounded metal drum electrode 120 supported rotatably; a needle-shaped or blade-shaped high-voltage electrode 130 provided facing the grounded metal drum electrode 120; an electrostatic electrode 140 provided facing the grounded metal drum electrode 120 downstream of the high-voltage electrode 130 in a rotation direction of the grounded metal drum electrode 120 (clockwise in the figure); a brush 150 for removing powder adhering to the grounded metal drum electrode 120; and a separation container 160 for separately storing the selected powder.

Each of the constituent members may be a conventionally known member. For example, the supply unit 110 may be a vibration feeder, the high-voltage electrode 130 may be a pin electrode, and the electrostatic electrode 140 may be an oval electrode. FIG. 2 shows a case where the separation container 160 is divided into five areas, but the separation container 160 may be divided into at least three areas so as to be able to distinguish between an adhering matter, falling matter, and bouncing matter, which will be described later. Positions of the high-voltage electrode 130 and the electrostatic electrode 140, distances of these to the grounded metal drum electrode 120, and positions of the partition plates (L₁ to L₅ in FIG. 2) that partition the separation container 160 may be changed appropriately depending on electrostatic conditions described below.

Next, electrostatic separation for the crushed material will be described.

First, in the electrostatic separator 100, a voltage is applied between the grounded metal drum electrode 120 and the high-voltage electrode 130 to generate a corona discharge. This causes the air between the grounded metal drum electrode 120 and the high-voltage electrode 130 to be ionized. The crushed material is then supplied from the supply unit 110 onto a grounded metal drum electrode 120. The crushed material is transported to a region between the grounded metal drum electrode 120 and the high-voltage electrode 130 as the grounded metal drum electrode 120 rotates. At this time, the ions cause the crushed material to be charged to the same sign as the electrode. Then, the charged crushed material passes through a region where the air is ionized and is transported into the region between the grounded metal drum electrode 120 and the electrostatic electrode 140 (an electrostatic field). The charged crushed material releases a charge in the electrostatic field. At this time, each powder contained in the crushed material releases an electric charge at a rate in accordance with its electrical conductivity. For example, in the crushed material, the powder with high conductivity quickly releases the electric charge and becomes electrically neutral, and then receives the electric charge from the grounded metal drum electrode 120, bounces off the grounded metal drum electrode 120 and falls while being attracted to the electrostatic electrode 140. On the other hand, non-conductive powder releases electric charge slowly or not at all and is therefore attracted to an opposite electric charge of the grounded metal drum electrode 120, and transported while remaining adhering to the grounded metal drum electrode 120. Further, an adhesion manner of the non-conductive powder varies depending on its density, and powder with a higher density is more likely to fall freely, while powder with a lower density is more likely to be transported while remaining adhered to the surface. In this way, each powder contained in the crushed material falls from the grounded metal drum electrode 120 to a predetermined position in accordance with its conductivity and density, and is appropriately separated at each drop position.

Specifically, due to the electrostatic separation, the metal powder, cell powder, resin powder and glass powder contained in the crushed material are separated into an adhering matter that adheres to the grounded metal drum electrode 120 and is separated, a falling matter that falls from the grounded metal drum electrode 120 due to its own weight and is separated, and a bouncing matter that bounces from the grounded metal drum electrode 120 and is separated, in accordance with their density and conductivity. In FIG. 2, the adhering matter is separately stored in areas 1 to 3 of the separation container 160, the falling matter in area 4, and the bouncing matter in area 5, respectively.

The metal powder bounces or falls due to its own weight from the grounded metal drum electrode 120 and is separated as a bouncing or falling matter. Even with the metal powders, those with high density and being heavy weight have difficulty in bouncing and fall due to their own weight, thus sometimes being separated as a falling matter. For example, among the metal powders derived from the metal wiring 12, those with a relatively large particle size are heavy and therefore tend to fall due to their own weight, and may be separated as a falling matter.

The resin powder adheres to the grounded metal drum electrode 120 or falls due to its own weight, and is separated mainly as an adhering matter or falling matter. The higher the applied voltage, the more easily the resin powder adheres to the grounded metal drum electrode 120, and such a resin powder is transported while remaining adhering to the grounded metal drum electrode 120, and physically recovered by a brush 150. Further, for example, due to a large particle size or a large rotation speed of the grounded metal drum electrode 120, resulting in a high centrifugal force acting on the particles, some of the resin powder may also be separated as a falling matter. The resin powder may also be separated as a bouncing matter, although in a very small amount.

The glass powder is separated as a falling matter or a bouncing matter. Although the glass powder is non-conductive like the resin powder, it has a higher density than the resin powder and is therefore more likely to be separated as a falling matter due to its own weight. Further, depending on the rotation speed of the grounded metal drum electrode 120 and the applied voltage, bouncing of the glass powder may occur due to a centrifugal force caused by the rotation, and in this case, the glass powder may also be separated as a bouncing matter.

The silicon powder (hereinafter also referred to as cell powder) derived from the solar cell 11 is separated in the same manner as the metal powder, but since the silicon powder has a smaller dense and lighter weight than metal powder, it tends to be separated as a bouncing matter rather than a falling matter.

The electrostatic conditions for electrostatic separation of the crushed material include a voltage applied to the grounded metal drum electrode 120, a rotation speed of the grounded metal drum electrode 120, and installation positions of the high-voltage electrode 130 and the electrostatic electrode 140. These conditions may be appropriately changed to allow the crushed material to be separated into a bouncing matter, falling matter, and adhering matter. In the electrostatic separator shown in FIG. 2, wiring branches out from one high-voltage power source, and the same voltage is applied to both the high-voltage electrode 130 and the electrostatic electrode 140. It is assumed below that the voltages applied to the high-voltage electrode 130 and the electrostatic electrode 140 are the same. However, the voltages applied to the high-voltage electrode 130 and the electrostatic electrode 140 may be different.

The applied voltage is a parameter that controls, particularly, the bouncing of the metal powder and the adhesion of the resin powder in the crushed material. It is desirable for the applied voltage to be high from a viewpoint of causing the metal powder to bounce while causing the resin powder to adhere. Specifically, the applied voltage is preferably 18 kV or more and less than 30 kV, and more preferably 20 kV or more and less than 30 kV. By setting the voltage at 18 kV or higher, corona discharge can be generated to sufficiently charge the crushed material, thereby increasing the proportion of metal powder in the bouncing matter. On the other hand, by applying a voltage of less than 30 kV, the crushed material can be separated efficiently while suppressing the generation of sparks.

The rotation speed of the grounded metal drum electrode 120 varies the magnitude of the centrifugal force acting on the crushed material, and is a parameter that mainly controls the bouncing of the metal powder and glass powder contained in the crushed material. The rotation speed is preferably set to a value that allows the metal powder to bounce while suppressing the glass powder from bouncing, allowing the glass powder to fall due to its own weight. Specifically, the rotation speed is preferably 20 rpm or more and 60 rpm or less. By setting the rotation speed to an appropriate value in a range of 20 rpm to 60 rpm and appropriately setting the applied voltage, the bouncing of the metal powder can be promoted while suppressing the bouncing of the glass powder, and the metal powder can be more reliably separated as a bouncing matter and the glass powder as a falling matter.

Further, regarding the placement of the high-voltage electrode 130 and the electrostatic electrode 140, distances Di and D₂ from the grounded metal drum electrode 120 and angles θ1 and θ2 in a rotation direction of the grounded metal drum electrode 120 are not particularly limited, and can be changed appropriately depending on the type of crushed material supplied from the supply unit 110, the applied voltage, and the rotation speed of the grounded metal drum electrode 120. Similarly, the distance d1 of the separation container 160 from the grounded metal drum electrode 120 may also be changed appropriately depending on the content of the crushed material supplied from the supply unit 110, the applied voltage, and the rotation speed of the grounded metal drum electrode 120. Further, widths L1 to L5 of the partitioned areas 1 to 5 in the separation container 160 may also be appropriately changed according to the electrostatic conditions.

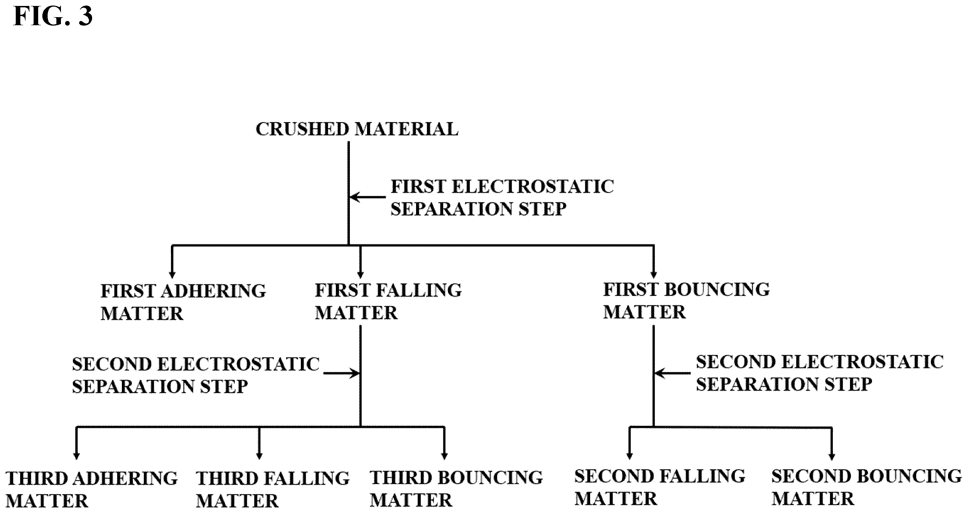

Further, in the electrostatic separation step, the electrostatic separation may be repeated. When the crushed material is electrostatically separated, the electrostatic separation can be repeated one or more times for the separated material at each drop position from the grounded metal drum electrode 120. For example, as shown in FIG. 3, when the above-described step of electrostatically separating the crushed material is set as a first electrostatic separation step, it is preferable to provide a second electrostatic separation step of further performing electrostatic separation to the separated material separated at each drop position in the first electrostatic separation step. At this time, it is preferable to perform the second electrostatic separation step to each of the first bouncing matter and the first falling matter in the separated materials separated at each drop position. The first bouncing matter and the first falling matter contain not only the metal powder but also the glass powder and resin powder. So, by further electrostatically separating these, the metal powder, the glass powder and resin powder contained therein can be more suitably separated. In this way, by sorting the separated material obtained in the electrostatic separation step and repeatedly performing the electrostatic separation step, the quality of the cell powder, metal, resin and glass in the separated material can be improved.

Specifically, the first bouncing matter contains cell powder, metal powder, and a small amount of glass powder. By further electrostatically separating the first bouncing matter, the glass powder contained in the first bouncing matter is allowed to fall due to its own weight, while the cell powder and metal powder are allowed to bounce, so that they can be separated. This makes it possible to obtain, from the first bouncing matter, a second bouncing matter having a higher ratio of cell powder and metal powder, and a second falling matter having a higher ratio of glass powder.

Further, the first falling matter includes not only glass powder and resin powder but also metal powder. By making the first falling matter subjected to electrostatic separation, each powder contained in the first falling matter can be further separated. This allows to obtain a third bouncing matter having a high ratio of cell powder and metal powder, a third falling matter having a high ratio of glass powder, and a third adhering matter having a high ratio of resin powder, from the first falling matter.

In the second electrostatic separation step, the rotation speed of the grounded metal drum electrode 120 is preferably set to be slower than that in the first electrostatic separation step. With such a small rotation speed, the centrifugal force applied to each powder is reduced, and the bouncing of the glass powder (particularly the glass powder having a small particle size and being lightweight) can be suppressed while promoting the bouncing of the conductive cell powder and metal powder. That is, when the bouncing matter and the falling matter are electrostatically separated, the cell powder, the metal powder and the glass powder can be more effectively separated. Specifically, the rotation speed is preferably set to 40 rpm or more and 60 rpm or less. The applied voltage is increased from that in the first electrostatic separation step while the drum rotation speed is decreased, thereby facilitating separation of the cell powder, metal powder and glass powder. Further, the separation efficiency can be improved by repeating the separation step.

In FIG. 3, explanation is given for a case in which the electrostatic separation is performed twice, but it may be performed three or more times. In this case, the crushed material is subjected to electrostatic separation, and the resulting separated material is subjected to electrostatic separation two or more times. For example, the electrostatic separation is preferably repeatedly performed to the bouncing matter and falling matter among the separated materials obtained by electrostatic separation. The conditions for each electrostatic separation are not particularly limited, but it is preferable to set the rotation speed of the grounded metal drum electrode 120 in the electrostatic separation performed in the latter stage to be smaller than that in the electrostatic separation performed in the former stage. Alternatively, it is preferable to make the voltage applied to the grounded metal drum in the electrostatic separation performed in the latter stage higher than that in the electrostatic separation performed in the former stage. More preferably, the rotation speed in the electrostatic separation performed in the latter stage is smaller than that in the former stage, and the applied voltage in the electrostatic separation performed in the latter stage is larger than that in the former stage.

As described above, by electrostatically separating the crushed material obtained by crushing the solar cell module 1, cell, metal, resin and glass can be respectively separated as a bouncing matter, falling matter and adhering matter in accordance with their electrical conductivity and density.

From a viewpoint of recovering metal from the solar cell module 1 at a high concentration rate, it is preferable to recover the first bouncing matter obtained after the first electrostatic separation step. Further, in the case of further performing the second electrostatic separation step, it is preferable to recover the second bouncing matter and the third bouncing matter.

The second bounding matter contains silicon powder (cell powder) derived from the solar cell 11 as well as metal powder. The second bouncing matter may be further electrostatically separated to separate the metal powder and the cell powder. Since the metal powder derives from the metal wiring 12, it tends to be elongated in shape and have a large particle size. On the other hand, the cell powder is finely ground compared to metal powder, and is tend to have a small particle size. Therefore, since the metal powder is heavy compared to the cell powder, the metal powder can be separated as a falling matter and the cell powder as a bouncing matter by electrostatic separation. As electrostatic conditions at this time, it is preferable to reduce the applied voltage and the rotation speed of the grounded metal drum electrode 120, from a viewpoint of making the metal powder fall due to its own weight while making the cell powder bounce. For example, it is preferable that the applied voltage is 18 kV or more and 22 kV or less, and the rotation speed is 20 rpm or more and 40 rpm or less.

According to the present embodiment, the frame-removed material of the solar cell module 1 is crushed as it is without removing the glass substrate 15 from the frame-removed material, and the crushed material thus obtained is electrostatically separated, to thereby separate into metal, resin and glass in accordance with their conductivity and density, and each can be separated into a bouncing matter, falling matter and adhering matter. Therefore, it is easy to remove the frame from the solar cell module. This makes it possible to omit a glass removal step that was previously required and possible to separate and recover metal through a simple process. In addition, crushing and electrostatic separation are simple processes, and therefore it is possible to process a large number of solar cell modules 1 using existing equipment.

Further, cells and metals can be separated from the crushed material of the flame-removed material with high concentration and recovery rates. Specifically, the concentration rate can be increased to 13 times or more, and the recovery rate can be increased to 52% or more. Here, the concentration rate indicates, for example, the rate obtained by dividing the concentration of the recovered metal by the metal concentration in a raw material. Further, the recovery rate indicates, for example, the rate obtained by dividing the weight of a recovered metal by the weight of a raw metal.

Further, in the electrostatic separation step, the applied voltage is preferably set to 18 kV or more and less than 30 kV. This makes it possible to easily separate the resin powder as an adhering matter and the metal powder as a bouncing matter while suppressing the generation of sparks. That is, the metal powder, the resin powder, and the glass powder can be more effectively separated.

Further, in the electrostatic separation step, the rotation speed of the grounded metal drum electrode 120 is preferably set to 20 rpm or more and 60 rpm or less. By adjusting the rotation speed, the centrifugal force acting on the crushed material can be reduced, and the bouncing of the glass powder, particularly of a small particle size, can be suppressed, thus facilitating the separation from the bouncing metal powder.

Further, after subjecting the crushed material to the first electrostatic separation step, it is preferable to further subject the resulting falling matter and bouncing matter to a second electrostatic separation step, and preferable to set the rotation speed of the grounded metal drum electrode 120 in the second electrostatic separation process to be smaller than that in the first electrostatic separation step. This makes it possible to further separate the metal powder and glass powder that are mixed in the bouncing and falling matters. That is, it becomes possible to recover metals from the crushed material at a higher concentration rate.

Further, in the present embodiment, in addition to collecting the bouncing matter from the crushed material to recover the metal powder, it is also possible to collect the adhering matter to recover the resin powder, and the falling matter to recover the glass powder.

### Example

Next, the present invention will be described in more detail based on examples, but the present invention is not limited to these examples.

### (Example 1)

In example 1, as samples simulating the components of a frame-removed material obtained by removing the frame from the solar cell module, metal powder, resin powder, and glass powder were prepared, and for these powders, the difference in separation due to electrostatic conditions and particle size was confirmed.

Specifically, a solar cell (hereinafter, simply referred to as a cell) was crushed to prepare a powder of the cell (Si powder). The particle size of the powder in the cell was 0.5 mm to 2 mm.

Further, metal wiring, so-called tab wire (copper), was crushed to prepare a powder of the tab wire (tab wire powder). The particle size of the tab wire powder was 1 mm to 5 mm.

Further, ethylene-vinyl acetate copolymer (EVA) and PET, which are used as sealing members and protective members, were prepared and crushed to prepare a resin powder. Two types of resin powder were prepared: one with a particle size of 3 mm or less, and one with a particle size of 3 mm to 5 mm.

Further, the glass substrate was crushed to prepare a glass powder. Two types of glass powder were prepared: one with a particle size of 3 mm or less, and the other with a particle size of 3 mm to 5 mm.

For the electrostatic separation, an electrostatic separator whose cross section is shown in FIG. 2 was used. The grounded metal drum electrode was configured to rotate clockwise and had a radius of 150 mm. A pin electrode, which is a high-voltage electrode, was positioned so that θ₁ was 45° and a distance D₁ from the grounded metal drum electrode was 40 mm. An oval electrode, which is an electrostatic electrode, was placed so that θ₂ was 70° and a distance D₂ from the grounded metal drum electrode was 120 mm. Further, a separation container was divided into five areas, designated areas 1 to 5. The widths of areas L₁ to L₅ were as follows: L₁ was 100 mm, L₂ was 140 mm, L₃ was 140 mm, L₄ was 100 mm, and L₅ was 200 mm. Then, the separation container was installed so that areas 1 to 3 were used to recover an adhering matter, area 4 was used to recover a falling matter, and area 5 was used to recover a bouncing matter. Further, a distance d₁ between the separation vessel and the grounded metal drum electrode was 30 mm.

Next, for each of the powder samples prepared, electrostatic separation was performed using the electrostatic separator described above, with the electrostatic conditions being changed in various ways, including the rotation speed of the grounded metal drum electrode and the applied voltage. Specifically, the rotation speed was changed to 0 rpm, 20 rpm, 40 rpm, and 60 rpm, and the applied voltage was changed to 0 kV, 18 kV, 22 kV, and 26 kV, respectively. The weight of the material recovered in each area of the separation container was measured, and a distribution rate to each area was calculated. The results are shown in tables 1 to 3 below.

**[Table 1]**

| Drum rotation speed | Applied voltage | Metal powder of metal pattern (tab wire) | | | | | Cell powder | | | | |
|---|---|---|---|---|---|---|---|---|---|---|---|
| | | Distribution rate (%) | | | | | Distribution rate (%) | | | | |
| [rpm] | [kV] | Area 1 | Area 2 | Area 3 | Area 4 | Area 5 | Area 1 | Area 2 | Area 3 | Area 4 | Area 5 |
| 20 | 0 | 0 | 0 | 0 | 100 | 0 | 0 | 0 | 0 | 100 | 0 |
| | 18 | 0 | 0 | 0 | 100 | 0 | 0 | 0 | 0 | 42 | 58 |
| | 22 | 0 | 0 | 0 | 94 | 6 | 0 | 0 | 0 | 38 | 62 |
| | 26 | 0 | 0 | 0 | 86 | 14 | 0 | 0 | 0 | 31 | 69 |
| 40 | 0 | 0 | 0 | 0 | 100 | 0 | 0 | 0 | 0 | 100 | 0 |
| | 18 | 0 | 0 | 0 | 92 | 8 | 0 | 0 | 0 | 37 | 63 |
| | 22 | 0 | 0 | 0 | 79 | 21 | 0 | 0 | 0 | 35 | 65 |
| | 26 | 0 | 0 | 0 | 72 | 28 | 0 | 0 | 0 | 29 | 71 |
| 60 | 0 | 0 | 0 | 0 | 93 | 7 | 0 | 0 | 0 | 96 | 4 |
| | 18 | 0 | 0 | 0 | 59 | 41 | 0 | 0 | 0 | 41 | 59 |
| | 22 | 0 | 0 | 0 | 58 | 42 | 0 | 0 | 0 | 34 | 66 |
| | 26 | 0 | 0 | 0 | 60 | 40 | 0 | 0 | 0 | 35 | 65 |

As shown in table 1, it is found that as the drum rotation speed decreases, the tab wire powder is less likely to bounce and is more likely to separate as a falling matter in area 4, even when the applied voltage is increased. Although a conductive metal powder is generally easy to bounce, it is believed that as the particle size increases and the weight increases, it becomes difficult for the powder to bounce using an electrical force alone. On the other hand, it is found that as the drum rotation speed increases, the centrifugal force acting on the powder increases, making the tab wire powder more likely to bounce and to be separated as a bouncing matter in area 5.

It is found that the cell powder has a tendency to be separated in the same way as tab wire powder, but is less affected by a drum rotation speed compared to the tab wire powder. This is considered to be because the cell powder has a low density and is lightweight, so it is less affected by a centrifugal force and more affected by an electrical force, making it easier for it to bounce.

As shown in table 1, it was confirmed that reducing the applied voltage and the rotation speed of the grounded metal drum electrode were effective, from a viewpoint of the electrostatic separation of the tab wire powder and cell powder derived from the metal wiring. For example, the applied voltage may be set to 18 kV or more and 22 kV or less, and the rotation speed may be set to 20 rpm or more and 40 rpm or less.

**[Table 2]**

| Drum rotation speed | Applied voltage | Resin powder (3mm or less) | | | | | Resin powder (3mm to 5mm) | | | | |
|---|---|---|---|---|---|---|---|---|---|---|---|
| | | Distribution rate (%) | | | | | Distribution rate (%) | | | | |
| [rpm] | [kV] | Area 1 | Area 2 | Area 3 | Area 4 | Area 5 | Area 1 | Area 2 | Area 3 | Area 4 | Area 5 |
| 20 | 0 | 0 | 0 | 0 | 100 | 0 | 0 | 0 | 0 | 100 | 0 |
| | 18 | 12 | 4 | 25 | 59 | 0 | 5 | 7 | 16 | 73 | 0 |
| | 22 | 57 | 9 | 24 | 10 | 0 | 41 | 13 | 27 | 18 | 0 |
| | 26 | 73 | 8 | 13 | 6 | 0 | 54 | 11 | 20 | 14 | 0 |
| 40 | 0 | 0 | 0 | 0 | 100 | 0 | 0 | 0 | 0 | 97 | 3 |
| | 18 | 8 | 2 | 18 | 71 | 1 | 4 | 2 | 12 | 81 | 1 |
| | 22 | 53 | 8 | 28 | 11 | 0 | 42 | 8 | 26 | 23 | 0 |
| | 26 | 79 | 5 | 12 | 4 | 0 | 57 | 8 | 20 | 15 | 0 |
| 60 | 0 | 0 | 0 | 0 | 78 | 22 | 0 | 0 | 0 | 55 | 45 |
| | 18 | 6 | 1 | 12 | 80 | 2 | 2 | 1 | 5 | 87 | 4 |
| | 22 | 45 | 6 | 25 | 24 | 0 | 26 | 4 | 22 | 47 | 1 |
| | 26 | 73 | 6 | 13 | 8 | 0 | 51 | 6 | 19 | 24 | 0 |

As shown in table 2, it was found that, regardless of the drum rotation speed, the higher the applied voltage, the more easily the resin powder adheres to the grounded metal drum electrode and is easily separated as an adhering matter in areas 1 to 3. This tendency was the same regardless of the particle size of the resin powder. Further, it was found that the resin powder was less likely to bounce even when the drum rotation speed was increased. This is considered to be because, in the case of the resin powder, adhesion due to electrical force has a greater effect than the centrifugal force due to rotation.

**[Table 3]**

| Drum rotation speed | Applied voltage | Glass powder (3mm or less) | | | | | Glass powder (3mm to 5mm) | | | | |
|---|---|---|---|---|---|---|---|---|---|---|---|
| | | Distribution rate [%] | | | | | Distribution rate [%] | | | | |
| [rpm] | [kV] | Area 1 | Area 2 | Area 3 | Area 4 | Area 5 | Area 1 | Area 2 | Area 3 | Area 4 | Area 5 |
| 20 | 0 | 0 | 0 | 0 | 98 | 2 | 0 | 0 | 0 | 97 | 3 |
| | 18 | 0 | 0 | 0 | 98 | 2 | 0 | 0 | 0 | 96 | 4 |
| | 22 | 0 | 0 | 0 | 98 | 2 | 0 | 0 | 0 | 98 | 2 |
| | 26 | 0 | 0 | 0 | 99 | 1 | 0 | 0 | 0 | 99 | 1 |
| 40 | 0 | 0 | 0 | 0 | 87 | 13 | 0 | 0 | 0 | 86 | 14 |
| | 18 | 0 | 0 | 0 | 86 | 14 | 0 | 0 | 0 | 86 | 14 |
| | 22 | 0 | 0 | 0 | 96 | 4 | 0 | 0 | 0 | 98 | 2 |
| | 26 | 0 | 0 | 0 | 96 | 4 | 0 | 0 | 0 | 99 | 1 |
| 60 | 0 | 0 | 0 | 0 | 41 | 59 | 0 | 0 | 0 | 39 | 61 |
| | 18 | 0 | 0 | 0 | 55 | 45 | 0 | 0 | 0 | 52 | 48 |
| | 22 | 0 | 0 | 0 | 94 | 6 | 0 | 0 | 0 | 95 | 5 |
| | 26 | 0 | 0 | 0 | 94 | 6 | 0 | 0 | 0 | 96 | 4 |

As shown in table 3, it was found that the glass powder, regardless of the particle size, was separated as a falling matter in area 4 or as a bouncing matter in area 5, and was not separated as an adhering matter. Further, it was found that the glass powder was more likely to fall due to its own weight as the drum rotation speed decreased, and was more likely to bounce as the drum rotation speed increased. Further, it was found that even when the drum rotation speed was increased, bouncing could be suppressed by adhesion to the grounded metal drum electrode by increasing the applied voltage.

From the above results, it was confirmed that the tab wire powder, cell powder, resin powder and glass powder could be separated by adjusting the drum rotation speed and applied voltage. For example, when the particle size of the resin powder and the glass powder is 3 mm or less, by performing electrostatic separation with the grounded metal drum electrode rotating at 60 rpm and the applied voltage set at 26 kV, 35% of the cell powder can be separated in area 4 as a falling matter and 65% of the cell powder can be separated in area 5 as a bouncing matter. Further, 60% of the tab wire powder can be separated in area 4 as a falling matter and 40% of the tab wire powder can be separated in area 5 as a bouncing matter. Further, 92% of the resin powder can be separated as an adhering matter in areas 1 to 3, and 94% of the glass powder can be separated as a falling matter in area 4.

### (Example 2)

In example 2, a sample simulating the crushed material of the frame-removed material of an actual solar cell module was prepared, and electrostatic separation was performed to this sample using the same electrostatic separator as in example 1.

First, a sample was prepared. Specifically, 6 g of the tab wire powder and 12 g of the cell powder used in example 1, 48 g of resin powder with a particle size of 3 mm or less derived from the sealing member and protective member, and 320 g of glass powder with a particle size of 3 mm or less were mixed together to obtain a 386 g sample. This sample had the same composition ratio as the solar cell module (78.8 mass % glass, 11.8 mass % resin, 3.2 mass % cell, 1.4 mass % tab wire). The weight of each powder in the samples are summarized in table 4 below.

**[Table 4]**

| Sample breakdown | | | | | |
|---|---|---|---|---|---|
| | Glass powder | Resin powder | Cell powder | Tub wire powder | Total amount |
| Weight [g] | 320 | 48 | 12 | 6 | 386 |

Next, the prepared sample was subjected to electrostatic separation under the conditions of a grounded metal drum electrode rotation speed of 60 rpm and an applied voltage of 26 kV, to separate and recover a first adhering matter in areas 1 to 3, a first falling matter in area 4, and a first bouncing matter in area 5. The first adhering matter weighed 41.35 g and mainly contained resin powder. The first falling matter weighed 323.12 g and contained glass powder, cell powder, tab wire powder, and resin powder. The first bouncing matter weighed 19.98 g and contained glass powder, cell powder, and tab wire powder. The electrostatic separation results of the samples are summarized in table 5 below.

**[Table 5]**

| Electrostatic separation results of samples | | | |
|---|---|---|---|
| | First adhering matter | First falling matter | First bouncing matter |
| Weight [g] | 41.36 | 323.12 | 19.98 |
| Powder type | Resin powder | Glass powder Cell powder Tab wire powder Resin powder | Glass powder Cell powder Tab wire powder |

In example 2, for each of the first falling matter separated in space 4 and the first bouncing matter separated in area 5, electrostatic separation was further performed under conditions of a grounded metal drum electrode rotation speed of 40 rpm and an applied voltage of 26 kV.

The first bouncing matter was electrostatically separated, so that the second falling matter was separated and recovered in area 4, and the second bouncing matter was separated and recovered in area 5. The second falling matter weighed 12.93 g and mainly contained glass powder, with small amounts of cell powder and tab wire powder also being identified. The second bouncing matter weighed 5.65 g and mainly contained tab wire powder and cell powder, with a small amount of glass powder being identified. The electrostatic separation results for the first bouncing matter are summarized in table 6 below.

**[Table 6]**

| Electrostatic sorting results of first bouncing matter | | |
|---|---|---|
| | Second falling matter | Second bouncing matter |
| Weight [g] | 12.93 | 5.65 |
| Powder type | Glass powder Cell powder Tab wire powder | Cell powder Tab wire powder (small amount of glass powder) |

On the other hand, by electrostatically separating the first falling matter, the third adhering matter was separated and recovered in areas 1 to 3, the third falling matter in area 4, and the third bouncing matter in area 5. The third adhering matter weighed 6.18 g and mainly contained resin powder. The third falling matter weighed 299.5 g and mainly contained glass powder. The third bouncing matter weighed 8.44 g and mainly contained tab wire powder and cell powder, with a small amount of glass powder being identified. The electrostatic separation results of the first falling matter are summarized in table 7 below.

**[Table 7]**

| Electrostatic sorting results of first falling matter | | | |
|---|---|---|---|
| | Third adhering matter | Third falling matter | Third bouncing matter |
| Weight [g] | 6.18 | 299.5 | 8.44 |
| Powder type | Resin powder | Glass powder | Glass powder Cell powder Tub wire powder |

Next, the second falling matter, the second bouncing matter and the third bouncing matter were manually sorted and separated into the tab wire powder, cell powder and glass powder, and the weights of each were measured. The results are summarized in table 8 below. As shown in table 8, the second bouncing matter obtained by further electrostatically separating the first bouncing matter was confirmed to contain a total of 5.47 g of tab wire powder and cell powder, with 0.16 g of glass powder, which is a very small amount. On the other hand, the second falling matter separated at this time contained 3.3 g of tab wire powder and cell powder in total, but also contained 9.62 g of glass powder. From this result, it was confirmed that a high ratio of glass powder could be separated by further electrostatic separation of the first bouncing matter. Further, the third bouncing matter obtained by further electrostatically separating the first falling matter contained 4.51 g of glass powder, and 3.89 g of tab wire powder and cell powder in total. From this result, it was confirmed that by further electrostatically separating the first falling matter, metal such as tab wire powder that is mixed in can be recovered.

**[Table 8]**

| | Second falling matter | Second bouncing matter | Third bouncing matter |
|---|---|---|---|
| Total weight [g] | 12.93 | 5.65 | 8.44 |
| Weight [g] of glass powder | 9.62 | 0.16 | 4.51 |
| Weights [g] of tab wire powder and cell powder | 3.3 | 5.47 | 3.89 |

As described above, according to the present invention, the frame member is removed from the solar cell module, and the frame-removed material is crushed and subjected to electrostatic separation, to separate the resin and glass from the cell and metal wiring contained in the crushed material, in accordance with their conductivity and density. In other words, valuables such as cells and metal wiring can be sorted and concentrated.

### Description of signs and numerals

1. Solar cell module
11. Solar cell
12. Metal wiring
13. Sealing member
14. Protective member
15. Glass substrate
16. Frame member

## Claims

1. A method for processing a solar cell module, including:
removing a frame member from a solar cell module to obtain a frame-removed material;
crushing the frame-removed material to obtain a crushed material; and
electrostatically separating the crushed material,
wherein in the electrostatic separation, the crushed material is charged and separated in accordance with density and conductivity.

2. The method for processing a solar cell module according to claim 1,
wherein the solar cell module includes: a solar cell; metal wiring extending from the solar cell; a sealing member made of resin for sealing the solar cell and the metal wiring; a resin protective member provided on one surface of the sealing member; a glass substrate provided on the other surface of the sealing member; and a frame member surrounding these.

3. The method for processing a solar cell module according to claim 1 or 2, wherein in the crushing, the crushed material is crushed to have a particle size of 5 mm or less.

4. The method for processing a solar cell module according to any one of claims 1 to 3, wherein in the electrostatic separation, an applied voltage is set to 18 kV or more and less than 30 kV.

5. The method for processing a solar cell module according to any one of claims 1 to 4, wherein in the electrostatic separation, the crushed material is supplied to an electrostatic separator equipped with a grounded metal drum electrode, and a rotation speed of the grounded metal drum electrode is set to 20 rpm or more and 60 rpm or less.

6. The method for processing a solar cell module according to any one of claims 1 to 5,
wherein in the electrostatic separation, the crushed material is supplied to an electrostatic separator equipped with a grounded metal drum electrode, and electrostatic separation is repeated one or more times for the separated material separated at each drop position from the grounded metal drum electrode.

7. The method for processing a solar cell module according to claim 6, wherein in the electrostatic separation, a rotation speed of the grounded metal drum electrode in the electrostatic separation performed in a latter stage is set to be smaller than that in the electrostatic separation performed in a former stage, and/or a voltage applied to the grounded metal drum electrode in the electrostatic separation performed in the latter stage is set to be higher than that in the electrostatic separation performed in the former stage.
